# EUROPEAN PATENT SPECIFICATION

(11) **EP 2 926 382 B1**
(45) Date of publication and mention of the grant of the patent: **25.07.2018**
(21) Application number: 13799038.8
(22) Date of filing: 30.11.2013
(51) Int. Cl.: H01L 41/08, H01L 49/02, H01L 41/319

(54) **PREFERENTIALLY ORIENTED PEROVSKITE-RELATED THIN FILM**
BEVORZUGT ORIENTIERTE DÜNNSCHICHT IM ZUSAMMENHANG MIT PEROWSKIT
FILM MINCE LIÉ À LA PÉROVSKITE ORIENTÉ DE MANIÈRE PRÉFÉRENTIELLE

(30) Priority: 30.11.2012 EP 12195184
(43) Date of publication of application: 07.10.2015
(73) Proprietor: Universiteit Gent, 9000 Gent (BE)
(72) Inventor: BEECKMAN, Jeroen, 9550 Hillegem (BE); NEYTS, Kristiaan, 9000 Gent (BE); GEORGE, John Puthenparampil, 9000 Gent (BE)
(74) Representative: DenK iP
(86) International application number: PCT/EP2013/075189
(87) International publication number: WO 2014/083195

(56) References cited:
- WO-A1-2011/132532
- LE PAVEN-THIVET ET AL: "Oxynitride perovskite LaTiOxNy thin films deposited by reactive sputtering", PROGRESS IN SOLID STATE CHEMISTRY, PERGAMON PRESS, OXFORD, GB, vol. 35, no. 2-4, 1 January 2007 (2007-01-01), pages 299-308, XP022138216, ISSN: 0079-6786

## Description

### Field of the invention

The invention relates to the field of thin film perovskite material with electrooptic, piezoelectric and/or ferroelectric properties. More specifically it relates to an intermediate layer for growing preferentially oriented perovskite-related thin film material, such as Barium Titanate (BTO), Lithium Niobate, Lead Lanthanum Zirconate Titanate (PLZT), and Lead Zirconate Titanate (PZT) onto any substrate material.

### Background of the invention

Ferroelectric thin films possess good ferroelectric, dielectric, piezoelectric and electro-optic properties which may render such films useful in a wide range of applications, for example in thin-film capacitors, in non-volatile memories for data storage, in electro-optical devices, e.g. electro-optic modulators, or in MEMS devices. Barium Titanate (BTO), Lithium Niobate , Lead Zirconium Titanate (PLZT), and Lead Zirconium Titanate (PZT) are common materials used for the above applications. After deposition, the material should not be amorphous, it should be at least polycrystalline, preferably polycrystalline with preferential orientation. Preferential orientation means that the crystal axis is oriented with respect to the substrate surface in one single direction. Certainly for exploring the piezoelectric and the electro-optic properties, it is important to have a preferentially oriented film, as it shows superior properties.

Deposition of such materials faces a number of difficulties. Often high-temperature annealing is necessary to obtain good crystallinity. High temperature synthesis is not compatible with e.g. the CMOS technology.

In order to have crystallinity on different substrates, for example silicon and glass, it is necessary to use a buffer layer. This buffer layer has a twofold purpose: it acts as a diffusion barrier, and it acts as a seed layer because the lattice constant of the substrate (e.g. silicon) differs too much from the lattice constant of the ferroelectric material. Often this buffer has to be thick, for example several hundreds of nanometers, e.g. in order to avoid the interfacial reaction and to seed the ferroelectric material. Metallic buffer layers, such as titanium, platinum or gold layers, are often used, because the ferroelectric material has to be electrically contacted. This poses a problem for all optical applications in which optical absorption should be avoided.

Either very thick buffer layers are used or metallic buffer layers with high optical absorption.

US Patent Application US 2010/02062151 discloses a method for producing a single crystalline thin film.

US Patent Application US 2011/0311718 discloses a method for manufacturing thin-film dielectrics and capacitors on metal foils. Further structures and methods are known from WO 2011 / 132532 A1.

The epitaxial deposition of thin films on silicon substrates is a key technology for the development of thinner and smaller future photonics and electronic devices, with the current CMOS based fabrication platform. The leakage current, and optical scattering are expected to be much smaller on epitaxial thin films compared to the polycrystalline counterparts. However, the epitaxial growth of ferroelectric thin films on silicon substrates still remains to be a challenge. It has already been reported that the depositions at elevated temperatures cause severe reactions at the thin film / silicon interfaces which results in silicide formation and degradation of the quality of the thin films. Interdiffusion of silicon and the constituent elements at high temperature results in intermediate pyrochlore and secondary phase formation rather than the pure perovskite phase. Different methods have been proposed to use either a seed or an intermediate barrier layer to promote the crystal growth. Single crystalline substrates as well as oriented thin films of MgO (1 0 0), SrTiO3 (1 0 0), LaAlO3, SRO/CeO2/YSZ, LaNiO3 (1 0 0), and Pt /Ti / SiO2 may have been used to promote the growth of BaTiO3 thin films. However, it is reported that the structure and orientation of these thin film buffer materials can critically influence the subsequent ferroelectric thin film growth. It demands stringent deposition conditions and careful control of the processing parameters.

### Summary of the invention

It is an object of embodiments of the present invention to efficiently provide a good quality perovskite-related thin-film layer onto a substrate.

It is an advantage of embodiments of the present invention that a perovskite-related thin film layer of good quality can be provided by simple means on a variety of substrates, for example can be provided equally well on glass as on silicon or germanium.

It is an advantage of embodiments of the present invention that a perovskite-type thin layer can be provided on a substrate which requires only an intermediate layer of 20 nm thickness or less.

It is an advantage of embodiments of the present invention that the intermediate layer is an electrical insulator.

It is an advantage of embodiments of the present invention that the intermediate layer exhibits low optical absorption, e.g. for visible and near infrared light.

It is an advantage of embodiments of the present invention that solid-state microstructures with a perovskite-related thin-film layer can be manufactured using simple and cheap techniques.

It is an advantage of embodiments of the present invention that silicide formation does not impair the quality of the thin-film layers.

It is an advantage of embodiments of the present invention that intermediate pyrochlore and secondary phase formation are avoided in the thin-film layers.

It is an advantage of embodiments of the present invention that thin-film layers in substantially pure perovskite phase can be produced.

It is an advantage of embodiments of the present invention that substantially crack-free and uniform thin-film layers can be produced.

The above objective is accomplished by a method and device according to the present invention.

In a first aspect, the present invention provides a solid-state microstructure which comprises a substrate and an intermediate layer arranged on the substrate. This intermediate layer comprises a lanthanide oxynitrate, such as for example a lanthanum oxynitrate and/or a neodymium oxynitrate. The solid-state microstructure further comprises a thin-film layer arranged on the intermediate layer, in which the thin-film layer comprises a preferentially oriented perovskite-related material, such as a highly C-axis oriented perovskite-related material. Part of, a major part or the full material may have such a preferential orientation. Where in embodiments and claims of the present invention reference is made to a perovskite-related material, reference also may be made to a perovskite-type material or perovskite-like material. Such terminology includes but is not limited to perovskite materials. It was surprisingly found that by using an intermediate layer comprising a lanthanide oxynitrate, the conditions for obtaining a thin-film layer having a preferentially oriented perovskite-related material arranged on the intermediate layer are highly relaxed.

In a microstructure according to embodiments of the present invention, the intermediate layer may have a thickness less than 20 nm.

In a microstructure according to embodiments of the present invention, the preferentially oriented perovskite-related material may comprise barium titanate, barium zirconium titanate, strontium titanate, lead lanthanum zirconate titanate , lithium niobate or lead zirconate titanate.

In a microstructure according to embodiments of the present invention, the substrate may comprise for example silicon, germanium, MgO2, coated silicon with a Ti coating, coated silicon with a SiO₂ coating, coated silicon with an Al₂O₃ coating, glass or glass with an ITO coating.

In a second aspect, the present invention provides a method for manufacturing a solid-state microstructure, in which this method comprises obtaining a substrate and forming an intermediate layer on the substrate, in which the intermediate layer comprises a lanthanide oxynitrate. The method further comprises forming a thin-film layer on the intermediate layer, in which the thin-film layer comprises a preferentially oriented perovskite-related material, such as a highly C-axis oriented perovskite-related material.

In a method according to embodiments of the present invention, the intermediate layer may have a thickness of less than 20 nm.

The thickness of the intermediate layer may be selected larger than a predetermined minimum and lower than a predetermined maximum for assisting in allowing achieving preferential orientation.

In a method according to embodiments of the present invention, forming said intermediate layer comprises applying a chemical material onto the substrate, in which said chemical material comprises lanthanum nitrate. The chemical material may be a chemical solution.

In a method according to embodiments of the present invention, said chemical material may comprise spin-coating, dip coating, k-bar coating or screenprinting the chemical material onto the substrate. The chemical material may be a chemical solution.

In a method according to embodiments of the present invention, forming said intermediate layer may comprise applying a heat treatment to said intermediate layer in order to form lanthanum oxynitrate in said intermediate layer or applying a heat treatment to said intermediate layer at a temperature in the range from 440°C to 570°C in order to form lanthanide oxynitrate, e.g. lanthanum oxynitrate in said intermediate layer.

The temperature at which the heat treatment is performed may be selected to be larger than a predetermined temperature and lower than another predetermined temperature for assisting in allowing achieving preferential orientation.

In a method according to embodiments of the present invention, forming said intermediate layer may comprise applying a heat treatment to said intermediate layer in order to form lanthanide oxynitrate, e.g. neodymium oxynitrate, in said intermediate layer or applying a heat treatment to said intermediate layer at a temperature between 440°C and 570°C in order to form lanthanide oxynitrate, e.g. neodymium oxynitrate, in said intermediate layer.

In a method according to embodiments of the present invention, the method may furthermore comprise the step of applying an adhesion promoter to the substrate prior to applying said composition. The method may comprise the step of applying an adhesion promoter comprising a polyvinyl pyrrolidone solution to the substrate prior to applying said composition.

In a method according to embodiments of the present invention, forming a thin-film layer on said intermediate layer may comprise spin-coating, dip coating, k-bar coating or screen printing a precursor material, e.g. solution, for the preferentially oriented perovskite-related material.

In a method according to embodiments of the present invention, forming a thin-film layer on said intermediate layer further may comprise pyrolysis and/or annealing of the thin-film layer.

In a method according to embodiments of the present invention, forming a thin-film layer may comprise repeating at least once said spin coating and said pyrolyzing and/or annealing.

The present invention also relates to a device comprising a solid-state microstructure as described above, wherein the device is any of a piezoelectric actuator or sensor, an acousto-optic device, a ferroelectric data memory, a capacitor, an electro-optic modulator or an electro-optic switch, an elasto-optic device, a pyro-electric detector or a MEMS device.

The present invention also relates to the use of a solid-state microstructure as described above in any of a piezoelectric actuator or sensor, an acousto-optic device, a ferroelectric data memory, a capacitor, an electro-optic modulator or electro-optic switch, an elasto-optic device, a pyro-electric detector or a MEMS device.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows a schematic representation of a solid-state microstructure according to embodiments of the present invention.
FIG. 2 illustrates an exemplary method according to embodiments of the present invention.
FIG. 3 shows XRD patterns obtained for BTO thin films deposited at 700 °C, for different thicknesses of the intermediate layer, according to an embodiment of the present invention.
FIG. 4 shows XRD patterns obtained for BTO thin films deposited with an intermediate layer having a thickness of 8.9 nm, and a seed BTO layer of 30 nm, for different annealing temperatures (layer-by-layer annealing), according to an embodiment of the present invention.
FIG. 5 shows XRD patterns obtained for BTO thin films annealed at 700 °C after each 30 nm BTO layer deposition, or after four 30 nm BTO depositions (120 nm), according to an embodiment of the present invention.
FIG. 6 shows a SEM top view of BTO thin films, deposited at 700 °C, with intermediate layers of 6 nm thickness, according to an embodiment of the present invention.
FIG. 7 shows a SEM top view of BTO thin films, deposited at 700 °C, with intermediate layers of 7.2 nm thickness, according to an embodiment of the present invention.
FIG. 8 shows a cross sectional image that indicates the presence of an ultra-thin intermediate layer of 8.9 nm thickness, prepared by cleaving the silicon substrate, according to an embodiment of the present invention.
FIG. 9 shows an AFM image of the BTO film with an intermediate layer having a thickness of 7.2 nm, according to an embodiment of the present invention.
FIG. 10 shows a graph of the processed roughness data for the BTO film with an intermediate layer having a thickness of 7.2 nm shown in FIG. 19, according to an embodiment of the present invention.
FIG. 11 shows a graph of the dielectric constant versus the electric field measurements for a BTO thin film having a thickness of 150 nm, deposited with an intermediate layer of 7.2 nm thickness, according to an embodiment of the present invention.
FIG. 12 shows the P-E hysteresis loop measured at 1 KHz with an ac voltage swing of 10 V-PP for a BTO thin film having a thickness of 150 nm, deposited with an intermediate layer of 7.2 nm thickness, according to an embodiment of the present invention.
FIG. 13 shows XRD patterns obtained for PZT thin films annealed at 600 °C, for intermediate layers with different thicknesses, according to an embodiment of the present invention.
FIG. 14 shows XRD patterns obtained for PZT thin films annealed at 520 °C, for intermediate layers with different thicknesses, according to an embodiment of the present invention.
FIG. 15 shows XRD patterns obtained for Lead Lanthanum Zirconate Titanate (PLZT) thin film deposited with an intermediate layer thickness of 7.2 nm, and annealed at 600 °C, according to an embodiment of the present invention.
FIG. 16 shows a top view SEM image of the PZT film deposited at 600 °C with intermediate layer thickness of 8.9 nm, according to an embodiment of the present invention.
FIG. 17 shows a cross-sectional view SEM image of the PZT film deposited with intermediate layer thickness of 8.9 nm, according to an embodiment of the present invention.
FIG. 18 shows a top SEM image of the PZT film deposited at 520 °C with intermediate layer thickness of 8.9 nm, according to an embodiment of the present invention.
FIG. 19 shows a cross-sectional SEM image of the PZT film deposited at 520 °C with intermediate layer thickness of 8.9 nm, according to an embodiment of the present invention.
FIG. 20 shows the P-E hysteresis curve obtained for the PZT films deposited with an intermediate layers of different thickness at 520 °C, according to an embodiment of the present invention.
FIG. 21 shows the dielectric constant and dielectric loss as a function of applied voltage for the PZT films deposited at 520 °C, according to an embodiment of the present invention.
FIG. 22 shows XRD patterns obtained for LiNbO₃ thin films annealed at 650 °C, for intermediate layers with different thicknesses, according to an embodiment of the present invention
FIG. 23 shows an exemplary vertical sandwich Si - Ferroelectric thin film based slot structure comprising a solid-state microstructure according to embodiments of the present invention.
FIG. 24 shows a simulated mode profile of a slot waveguide structure with a solid-state microstructure according to embodiments of the present invention, in which the intermediate layer has a thickness of 10 nm.
FIG. 25 shows a simulated mode profile of a slot waveguide structure with a solid-state microstructure according to embodiments of the present invention, in which the intermediate layer has a thickness of 20 nm.
FIG. 26 shows a simulated mode profile of a slot waveguide structure with a solid-state microstructure according to embodiments of the present invention, in which the intermediate layer has a thickness of 30 nm.
FIG. 27 shows XRD patterns obtained for a PZT thin film deposited on a NdONO₃ buffer layer, annealed at 600 °C, according to embodiments of the present invention.
FIG. 28 shows XRD patterns obtained for a PZT thin film annealed at 600 °C, on PrONO₃ and PrO_{1.833} buffer layer, according to embodiments of the present invention.
FIG.29 shows the XRD patterns of the BaZr_{0.4}Ti_{0.6}O₃ thin film deposited on PrONO₃ buffer layer and annealed at 600 °C, according to the embodiments of the present invention.
FIG 30 shows the XRD pattern of the PZT thin film deposited on SmONO₃ buffer layer of different thickness, and annealed at 600 °C, according to the embodiments of the present invention.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Where in embodiments of the present invention reference is made to "a perovskite-related material", reference is made to a material with chemical composition ABX₃ with the same type of crystal structure as calcium titanium oxide (CaTiO₃), known as the perovskite structure, or ^{XII}A^{2+VI}B⁴⁺X²⁻₃ with the oxygen in the face centers (e.g. BaTiO₃), or reference is made to materials which are ternary oxides ABO₃ with a different crystal structure than the perovskite stucture, in which the A is at least one alkali metal or alkali earth metal and B is at least one metal (e.g. LiNbO₃). The general chemical formula for perovskite compounds is ABX₃, where 'A' and 'B' are two cations of very different sizes, and X is an anion that bonds to both. The 'A' atoms are larger than the 'B' atoms. The ideal cubic-symmetry structure has the B cation in 6-fold coordination, surrounded by an octahedron of anions, and the A cation in 12-fold cuboctahedral coordination. The relative ion size requirements for stability of the cubic structure are quite stringent, so slight buckling and distortion can produce several lower-symmetry distorted versions, in which the coordination numbers of A cations, B cations or both are reduced.

The 'A' atoms in the chemical structure can be a single chemical element (e.g. Ba in BaTiO₃), or a combination of different elements (e.g. Ba and Sr in Ba₁₋ₓSrₓTiO₃). The 'B' atoms can be a single element (e.g. Ti in BaTiO₃) or a combination of different elements (e.g. Zr and Ti in PbZr₁₋ₓTiₓO₃). In e.g. Pb_{1-y}La_{y}Zr₁₋ₓTiₓO₃ the stoichiometric coefficients x and y are independent.

Where in embodiments according to the present invention reference is made to an intermediate layer or buffer layer, reference is made to a layer that is positioned intermediate two layers.

In some embodiments, the thickness of the ferroelectric thin films may be in the range 20nm to several micrometer.

In a first aspect, the present invention relates to a solid-state microstructure which comprises a substrate, an intermediate layer arranged on this substrate and a thin-film layer arranged on the intermediate layer. The intermediate layer comprises a lanthanide oxynitrate, a lanthanide being an element with atomic number ranging from 57 (lanthanum) through 71 (lutetium). For example, the intermediate layer may comprise lanthanum oxynitrate (LaONO₃) or neodymium oxynitrate (NdONO₃), or even a mixture of lanthanum oxynitrates, e.g. a mixture LaₓNd₁₋ₓO(NO₃). The thin-film layer comprises a preferentially oriented perovskite-related material. Preferential orientation refers to an orientation of the crystal along a certain crystal axis, for example the C-axis. Thus, the thin-film layer may comprise a highly C-axis oriented perovskite-type material. For example, the solid-state microstructure may comprise the substrate, the thin-film layer and the intermediate layer, in which the intermediate layer is arranged between the substrate and the thin-film layer, e.g. the intermediate layer is arranged in direct contact with the substrate along a first surface of the intermediate layer and the intermediate layer is arranged in direct contact with the thin-film layer along a second surface of the intermediate layer, the second surface being substantially parallel to the first surface.

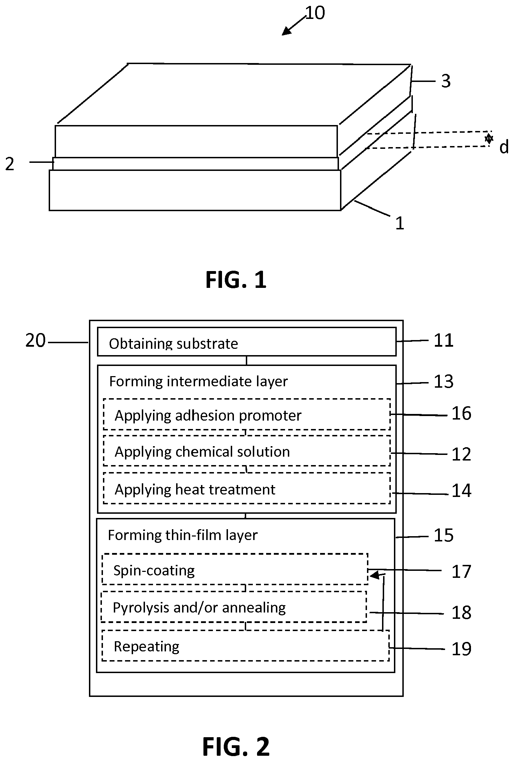

Referring to FIG. 1, a solid-state microstructure 10 according to an exemplary embodiment of the present invention is shown. This solid-state microstructure 10, e.g. a layered structure for use in an integrated circuit such as an electronic or photonic circuit or for use in a microelectromechanical system (MEMS), comprises a substrate 1, which may for example comprise a glass substrate, a semiconductor substrate, e.g; a silicon or germanium substrate, or a MgO₂ substrate. The substrate 1 may be a compound substrate, e.g. a coated glass substrate, such as an indium tin oxide (ITO) coated glass substrate, or a layered structure comprising silicon, such as a silicon on insulator (SOI) wafer substrate, silicon having a Ti, SiO₂ or Al₂O₃ layer provided thereon, or a silicon on sapphire substrate.

The intermediate layer 2, which is arranged on the substrate, comprises a lanthanide oxynitrate, e.g. lanthanum oxynitrate (LaONO₃) or neodymium oxynitrate (NdONO₃). This intermediate layer 2 may for example be formed, as further explained in relation to the second aspect of the present invention, by coating lanthanum nitrate, e.g. using a lanthanum nitrate hydrate solution in 2-propanol, onto the substrate 1 and applying a heat treatment to remove the solvent and decompose the lanthanum nitrate into lanthanum oxynitrate. It has been found that lanthanum nitrate thermally decomposes at temperatures above 400 °C, e.g. around 450 °C.

In embodiments according to the present invention, the intermediate layer 2 may have a thickness d of 20 nm or smaller, preferentially less than 15 nm, for example a thickness of 13 nm, or even more preferred, a thickness equal to or less than 10 nm, for example 6 nm, or even less than 6 nm, for example 3 nm. The minimum thickness for the thin film may be dependent on the type of thin film used. For example for PZT the minimum thickness may be chosen to be 3nm, for BTO the minimum thickness may be chosen to be 8nm. The maximum thickness used may in some embodiments for example be determined by the type of application and the material cost. This intermediate layer 2 may act as a suitable buffer layer, e.g. may protect from interdiffusion of the thin-film layer material and the substrate material, and the intermediate layer 2 may act as a suitable seed layer, e.g. allowing the growth of a smooth, crack-free and/or uniform thin-film layer 3 in a perovskite-related structural configuration. Such advantageous effect of the intermediate layer 2 may be achieved even when the intermediate layer is extremely thin, e.g. less than 10 nm. Furthermore, in particularly advantageous embodiments, the intermediate layer 2 may be substantially transparent to visible and/or near infrared light and/or may be an electrical insulator. Nevertheless, this intermediate layer is able to induce preferential orientation of the perovskite-related thin film applied thereon.

Surprisingly, it has been found that a solid-state microstructure 10 according to embodiments of the present invention, comprising the intermediate layer 2, even with a thickness of less than 10 nm, can induce a preferential orientation in a perovskite-related thin-film layer applied thereon for a wide range of substrate types, for example the intermediate layer may be applied equally well onto glass, glass with ITO or silicon. Furthermore, different types of thin-film layers of perovskite-related material seem to respond well to this intermediate layer, for example PZT and BTO.

The intermediate layer 2 may furthermore have the advantage of providing good electrical insulation, for example, for an intermediate layer obtained by heat-treating a lanthanum nitrate hydrate coated onto the substrate, as further detailed in relation to the second aspect of the present invention. Furthermore, such intermediate layer 2 may advantageously exhibit little optical absorption, e.g. for light in the visible and near infrared spectral range. A suitable intermediate layer 2 can furthermore be obtained by a simple and cheap chemical solution deposition method.

The thin-film layer 3, which is arranged on the intermediate layer 2, comprises a preferentially oriented perovskite-related material, for example the thin-film layer may be a highly C-axis oriented perovskite thin film. In embodiments of the present invention, the thin-film layer may comprise a Barium Titanate (BTO) thin film. In other embodiments, the thin-film layer may comprise a Lead Zirconate Titanate (PZT) thin film. In yet other embodiments, the thin-film layer may comprise another highly C-axis oriented perovskite-type material, such as strontium titanate, lanthanum titanate, lithium niobate, lead lanthanum zirconate titanate or barium zirconium titanate. The thin-film layer 3 may be grown over the intermediate layer 2, for example using a chemical solution deposition technique (CSD), as will be further described in relation to the second aspect of the present invention. It will be seen that thin-film layers which comprise a preferentially oriented perovskite-related material, e.g. a highly C-axis oriented perovskite-type material, are known to possess advantageous properties for a wide range of applications, as further described hereinbelow.

In a second aspect, the present invention relates to a method for manufacturing a solid-state microstructure, e.g. a solid-state microstructure 10 according to embodiments of the first aspect of the present invention. This method comprises the steps of obtaining a substrate and forming an intermediate layer on this substrate, in which the intermediate layer comprises a lanthanide oxynitrate, e.g. a lanthanium oxynitrate and/or a neodymium oxynitrate. The method also comprises forming a thin-film layer on the intermediate layer, in which this thin-film layer comprises a preferentially oriented peroskite-related material, e.g. a highly C-axis oriented perovskite-type material.

In FIG. 2, an exemplary method 20 according to the second aspect of the present invention is illustrated. In a first step, this method 20 comprises obtaining 11 a substrate 1, for example a silicon substrate, a germanium substrate, a MgO₂ substrate, a glass substrate or a layered substrate, e.g. a coated glass substrate, e.g. a indium tin oxide (ITO) coated glass substrate.

The method 20 also comprises the step of forming 13 an intermediate layer 2 on this substrate 1, in which the intermediate layer comprises a lanthanide oxynitrate, e.g. lanthanum oxynitrate or neodymium oxynitrate. In preferred embodiments of the present invention, this intermediate layer 2 may be formed 13 such that the intermediate layer 2 has a final thickness of less than 20 nm.

Forming 13 the intermediate layer 2 may comprise applying 12 a chemical solution onto the substrate 1, in which this chemical solution may comprise lanthanum nitrate. For example, the chemical solution may comprise a lanthanum nitrate hydrate.

Applying 12 this chemical solution may comprise spin-coating the chemical solution onto the substrate 1. Alternatively, applying 12 this chemical solution may comprise dip coating, k-bar coating, screen printing or another suitable technique as known in the art.

Forming 13 the intermediate layer 2 may also comprise applying 14 a heat treatment to the intermediate layer 2, e.g. heat-treating the chemical solution spin-coated onto the substrate 1, in order to form lanthanum oxynitrate in the intermediate layer. For example, applying 14 this heat treatment may comprise heating the intermediate layer 2 to a temperature above 400 °C, preferably to a temperature in the range from 440°C to 570°C, for example to a temperature of 450 °C. Such heat treatment may enable the thermal decomposition of lanthanum nitrate into lanthanum oxynitrate. Furthermore, such heat treatment may alternatively enable the thermal decomposition of neodymium nitrate into neodymium oxynitrate.

The method 20 may furthermore comprise the step of applying 16 an adhesion promoter to the substrate 1 prior to applying 12 this chemical composition, for example, such adhesion promoter may comprise a polyvinyl pyrrolidone solution.

Forming 15 a thin-film layer 3 on the intermediate layer 2 may comprise spin-coating 17 a precursor solution for the preferentially oriented perovskite-related material, for example precursor solution for forming PZT, PbTiO₃, LiNbO₃, LiTaO₃, SrTiO₃ and/or BaTiO₃. This step may comprise the application of a chemical solution deposition (CSD) technique, for example a 2-methoxy ethanol based chemical solution deposition technique. For example, a chemical solution deposition technique may be used in order to grow a highly C-axis textured Barium Titanate (BaTiO₃) film on the intermediate layer 2.

Forming 15 the thin-film layer 3 on the intermediate layer 2 may further comprise pyrolysis and/or annealing 18 of the thin-film layer.

In embodiments of the present invention, the thin-film layer 3 may be formed in multiple steps, e.g. alternating a spin-coating step 17 and a pyrolization step 18 over multiple iterations, for example 3 to 4 cycles of spin-coating and pyrolization. Thus, forming 15 a thin-film layer may comprise repeating 19 at least once the spin coating 17 and the pyrolyzing 18.

In a further aspect, the present invention relates to the use of a solid-state microstructure according to the first aspect of the present invention in a piezoelectric actuator or sensor, in an acousto-optic device, in a ferroelectric data memory, in a capacitor, in an electro-optic modulator or switch, in an elasto-optic device, in a pyro-electric detector or in a MEMS device. The advantageous use of such solid-state microstructure in these areas of application can be readily deduced from known properties of thin-films composed of preferentially oriented perovskite-related material, e.g. composed of highly C-axis oriented perovskite-type material. Such thin-films are known to possess many advantageous properties, such as high electro-optic coefficients, strong optical nonlinearities, high permittivity, high acousto-optic coefficients, ferroelectricity (large remnant polarization), pyroelectricity, piezoelectricity,....

Various aspects of the present invention are further elucidated by the examples provided hereinbelow. However, these examples are illustrative only and the present invention is not intended to be limited by such examples in any way.

### First example - preferentially oriented BaTiO₃ thin films deposited on silicon

In this first example, Barium Titanate (BaTiO₃) thin films are prepared with a conventional 2-methoxy ethanol based chemical solution deposition technique. Highly C-axis textured BTO thin films grown on silicon substrates with an ultra-thin intermediate layer of about 6 nm are attained by a method according to embodiments of the present invention. The influence of the intermediate layers as small as about 3 to 9 nm on the crystallization of BaTiO₃ films is illustrated in detail. The annealing temperature and buffer layer sintering conditions are furthermore evaluated in order to obtain good crystal growth. X-ray diffraction measurements show the growth of well oriented BTO thin films having a single perovskite phase with a tetragonal geometry. SEM and AFM results indicate the presence of smooth, crack free, uniform layers, with well packed crystal grains on the silicon surface. The dielectric and P-E hysteresis behaviour of a film having a thickness of 150 nm, deposited on a buffer layer of 7.2 nm, show a dielectric constant of 270, a remnant polarization (2Pᵣ) of 5 µC/cm², and a coercive field (E_{c}) of 100 kV/cm.

In this example, the BaTiO₃ thin film growth on silicon substrates using a sol-gel deposition technique is demonstrated. An ultra-thin lanthanum oxynitrate layer of approximately 6 nm to 10 nm, was used as an intermediate layer to promote the crystal growth. The influence of the thickness of the intermediate layer, the heat treatment and the deposition conditions for the BaTiO₃ thin films on the growth of well oriented, crack free, and smooth films was analyzed.

Reagent grade barium acetate Ba(CH₃COO)₂, and titanium butoxide Ti(C₄H₉O)₄, were chosen as the source materials for barium and titanium, whereas glacial acetic acid and 2-methoxy ethanol was used as the solvent, stabilizer and chemical modifier respectively. The molarity of the solution was controlled to achieve a film thickness of 30 to 50 nm on a single deposition and subsequent post-deposition temperature treatment. In order to investigate the thickness dependency of the intermediate layers on the crystallization of BaTiO₃, buffer solutions with different molar concentration were prepared by dissolving lanthanum nitrate hydrate in 2-propanol. Polyvinyl pyrrolidone (45 % in water) dissolved in 2-propanol was coated on to the silicon substrate as an adhesion layer prior to the buffer layer deposition. Firstly, the buffer layer was deposited by spin-coating the lanthanum nitrate buffer solution on to the silicon wafers at 3000 rpm for 45 seconds, and subjected to a heat treatment at 450 °C for 5 minutes. Secondly, the BTO precursor sols of 0.33M were spin coated at 3000 rpm for 45 seconds, followed by pyrolysis to remove the solvent and to burn out the organics on a hot stage at 350 °C. This process has been repeated over 2 - 3 steps to attain a film thickness of about 100 nm. In the subsequent steps, the silicon substrates with BTO amorphous films have been subjected to a high temperature heat treatment at 650 °C - 750 °C for 20 minutes, with a tube annealing furnace in the ambient air. The ramping rates for heating and cooling of the specimen in the annealing system were adjusted to 100 °C / min and 50 °C /min respectively. These processes can be repeated over many cycles to have an oriented thin film with desired thickness.

The samples were cleaned prior to X-ray diffraction measurements with acetone, isopropanol and de-ionized water. The measurements were carried out with a D8 Discover diffractometer (Bruker technologies Ltd.,) with CuKα radiation. The diffractograms were recorded for 2θ angles between 15° and 64°, with a step size of 0.004 °, and time step of 1.2 seconds.

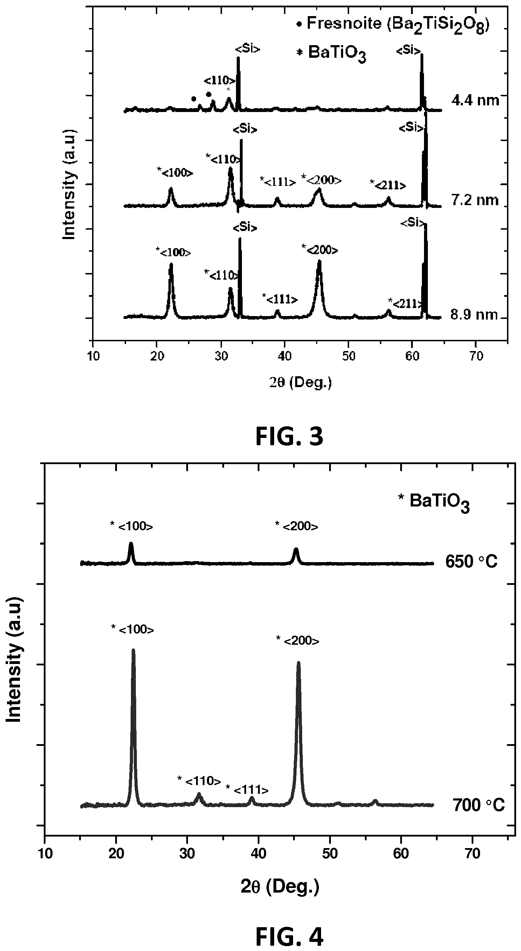

FIG. 3 to FIG. 5 shows the X-ray diffractograms of the BaTiO₃ thin films deposited on bare silicon substrate and subjected to a post deposition sintering treatment of 600 °C to 700 °C. The thicknesses of the BTO films are found to be 150 ± 2% nm, when measured with the help of an ellipsometer. A critical (minimum) thickness of the intermediate layer may in some embodiments be important to prevent the silicide formation at the Si-BTO interface, and also to promote the crystal growth with a desired orientation. The minimum thickness may in some embodiments be determined between 4.4nm and 7.2nm. To demonstrate the influence of intermediate layers precursor solutions of different molar concentrations were prepared and coated on to the bare silicon substrate.

It may be seen from FIG. 3 that when the buffer layer thickness is less than 4.4 nm, the secondary fresnoite phases (Ba₂TiSi₂O₈) are dominant. The films deposited at 600 °C, do not show any diffraction peaks of either fresnoite or BTO, which may indicate the amorphous nature of the film sintered at that temperature. The absence of the fresnoite silicate phases may also indicate that only negligible reactions may have taken place at the BTO / buffer layer interfaces due to the interdiffusion of Si at 600 °C. It was found from these exemplary experiments that a slightly thicker buffer layer of 7.2 nm may be sufficient to yield well defined diffraction peaks corresponding to stoichiometric BTO (BaTiO₃), with a mixed <100> and <111> orientation. The layer then is polycrystalline and every single crystal therein can have one of those orientations. A further increase in the buffer layer thickness may lead to a stronger diffraction intensity along the <100> orientation. However, the deposition of thicker buffer layers may be limited because of the poor adhesion of the lanthanum nitrate intermediate layer to the underlying PVP organic film. FIG. 3 represents a comparison between the BTO thin films deposited on silicon at 700 °C, with different thicknesses of the intermediate buffer layer. The XRD measurements verify that the films were crystallized into a pure perovskite phase, with a tetragonal geometry,.

It is also evident from the XRD measurements that the BTO thin films deposited with buffer layers of identical thickness (8 nm), but heat treated at two different temperatures show different crystallization properties. The different states of the intermediate layers (temperature dependent decomposition of lanthanum nitrate), under various heat treatments influenced the nucleation mechanism of the BTO films, and in turn results in different diffraction peaks in the XRD spectrum. The thin film deposited with buffer layer sintered at 575 °C shows a mixed orientation, with a strong diffraction peak along the <211> crystal peaks . The thickness, refractive index, and absorption properties of the buffer layers were verified, and further investigated with the help of an ellipsometer.

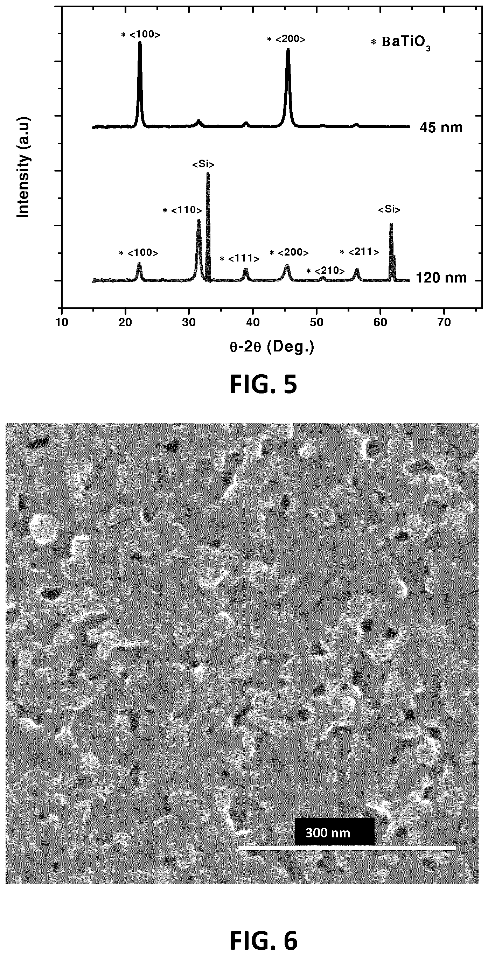

The dielectric, piezoelectric and electro optic properties of the thin film materials are known to be highly dependent on the crystal orientation. Highly c-axis oriented BTO thin films previously reported were critically influenced by the texturing of the underlying substrate or the orientation of intermediate activation layers. It is clear from FIG. 3 to 5 that the thicknesses and heat treatment of the intermediate layers have a major role in determining the orientations of the subsequently deposited BTO thin film. However, the use of a very thick intermediate layer can limit the performance of the ferroelectric films for certain specific applications, e.g. in electrooptic devices. The results shown in FIG. 4 and FIG. 5 indicate that c-axis textured BTO films may be grown, using a rather simple method (keeping the buffer layer thickness as constant ∼ 9 nm) according to embodiments of the present invention.

FIG. 4 and FIG. 5 represent the XRD pattern of the BTO films grown on a BTO seeding layer. The seed layers are prepared by depositing a thin layer (thickness of 30 nm) of BTO film on the intermediate layers (thickness of 8.9 nm), followed by pyrolysis (350 °C) and annealing (650 °C - 700 °C) heat treatments. It can be seen from FIG. 4 and FIG. 5 that the BTO thin film grown over a BTO seeding layer may show completely different crystallization properties, compared to the results mentioned in FIG. 3 . It may be observed that the BTO thin films grown by a layer-by-layer heat treatment method (single layer deposition of about 30 nm, followed by annealing) shows a preferential <100> orientation. The films annealed at both 650 °C and 700 °C show strong diffraction peaks along the <100> and <200> directions, with no sign of the secondary phase silicate formation. However, it can be seen from FIG. 5 that the films annealed after deposition of 120 nm BTO amorphous film deposited (prepared by 2-3 spin coating and pyrolysis steps) over the seed BTO layer show a stronger diffraction peak along the <110> direction (compared to the <100> direction). These experiments show that the orientation of the BTO thin films can be manipulated by controlling the thickness of the amorphous BTO films over the seed layers, before the final annealing treatments. Cross section images of the specimens were prepared by a FEI Nova 600 Nanolab Dual-Beam Focussed Ion Beam system (FIB) and associated Scanning Electron Microscope (SEM), which allows simultaneous milling and imaging of the specimens. The SEM column was equipped with a high-performance field-emission gun electron source, whereas the FIB system had a gallium Liquid Metal Ion Source (LMIS).

The scanning electron microscope (SEM) images of the BTO thin films grown on silicon <100> substrate with different thicknesses for the intermediate lanthanum oxynitrate barrier layers are presented in FIG. 6 to FIG. 86. It may be observed that the deposited films at 600 °C, with buffer layers of 6 nm, and 7.2 nm are amorphous and no distinct crystal grains are visible from the SEM measurements. Whereas, the films deposited with annealing temperature greater than 650 °C shows distinct crystal grains indicating the complete crystallization of the amorphous BTO films after high temperature annealing.

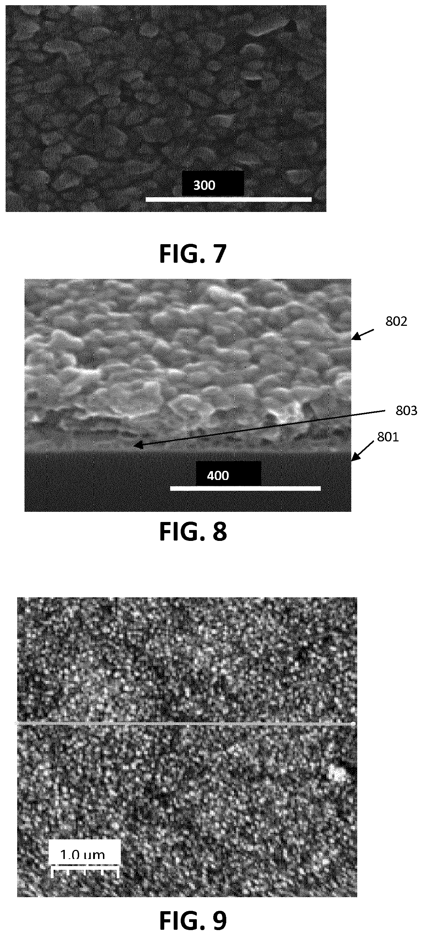

FIG. 6 and FIG. 7 show the top surface view of BTO films deposited at 700 °C, with intermediate layers of thickness 6 nm, 7.2 nm respectively. The presence of the well defined polygonal crystal grains is visible, and it shows the complete transformation of the amorphous films in to a perovskite phase at 700 °C. The presence of the intercrystal voids are evident on the BTO films (∼ 100 nm) deposited with buffer layers less than ∼ 6 nm (see FIG. 6). It may increase the chance of electrical short circuit between the bottom and the top evaporated Cr contact. The use of either thick BTO films or lithographically defined top electrical contacts (e.g. of 0.1 mm diameter) have been reported before to overcome this problem with the electrical characterization of the films. However, the present work shows that densities of the intercrystal voids can be decreased to a greater extent, by increasing thickness of the intermediate layers to 7.2 nm. The films deposited with BTO seed layer is further improving the quality of the thin films, and the films appear to have a dense microstructure. It is also found that as the thickness of the BTO amorphous film has been increased above 150 nm (over seed BTO layers), the subsequent annealing process results in nano-cracks on the film surface.
FIG. 7 shows a SEM top view of BTO thin films, deposited at 700 °C, with intermediate layers of 7.2 nm thickness. The grain sizes of the films deposited at 700 °C, with a intermediate layer having a thickness of 8.9 nm was found to be between 30- 90 nm, which may be comparable with the previously reported values for BTO thin films in the literature.
SEM cross-section images of the films were made by either cleaving or ion-milling the silicon samples. In FIG. 8, the silicon substrate 801, the BaTiO₃ material 802 and the 8.9nm thick buffer layer 803 are indicated. The cross section image of BTO thin film, deposited at 700 °C on a BTO seed layer of 30 nm, with an amorphous BTO film of 30 nm thickness (deposited on a layer-by-layer basis), is as shown in FIG. 8. The cleaving of the silicon samples causes rough sample edges, and also the brittle nature of the thin film results in numerous regions devoid of the material. The presence of the ultra-small intermediate buffer layer is evident, and matches with measurement data from the ellipsometer measurements...

The surface roughness of the deposited BTO thin films was measured by atomic force microscopy (AFM) analysis. The measurements were carried out with a Digital Instruments Dimension 3100 scanning probe microscope, in the contact mode.

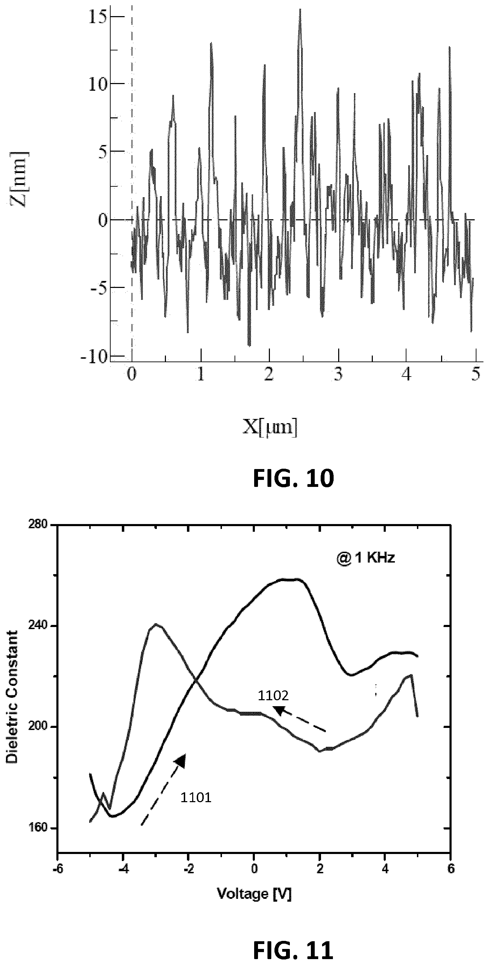

The AFM image with the processed roughness data of the BTO thin film (∼ 150 nm) annealed at 700 °C, with an intermediate buffer layer of 7.2 nm is as shown in FIG. 9 and FIG. 10.. The film deposited with 4.4 nm intermediate layer appears amorphous with an average roughness of approximately 10 nm, whereas dense micro structures are evident for the films deposited with buffer layers greater than 6 nm, with an average roughness of the films lying between 5 nm to 15 nm.

Capacitance versus voltage characteristics of the films were measured by using a HP4192ALF impedance analyser with a 4-probe measurement setup. Prior to the measurements, a top electrode was deposited with either chromium (Cr) or indium tin oxide (ITO) (area of 3.14 mm², thickness of 50 nm - 100 nm) by RF magnetron sputtering.

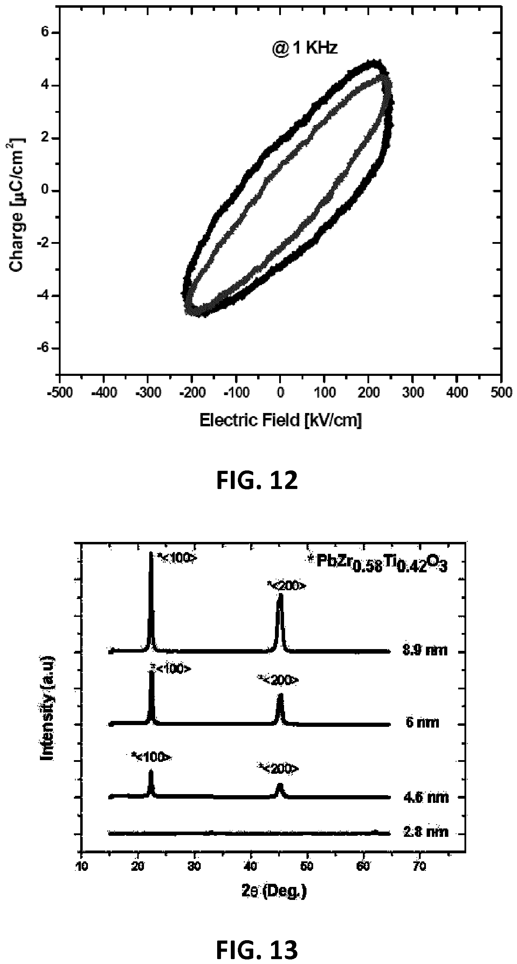

A sawyer tower circuit was used to obtain the polarization - electric field properties of the BTO thin films, by measuring the ferroelectric hysteresis loop. The measurements were carried out at frequencies between 100 Hz and 1 kHz with a sinusoidal ac-voltage swing of 10 V- PP.
The dielectric and ferroelectric properties of the as-deposited BTO thin films having a thickness of 150 nm were estimated with the capacitance-voltage (C-V) and polarization-electric field (P-E) measurements. The C-V measurements show a nonlinear dielectric response, with a characteristic butterfly shape, depicted in FIG.11, which indicates the ferroelectric hysteresis nature of the BTO tetragonal films. In FIG. 11 forward swing 1101 and backward swing 1102 are indicated. The two separate maxima for the dielectric constants with respect to 0 V is clearly observed depending on the direction of the electric field. FIG. 12 shows the P-E hysteresis loop measured at 1 KHz with an ac voltage swing of 10 V-PP for a BTO thin film having a thickness of 150 nm, deposited with an intermediate layer of 7.2 nm thickness.

The samples deposited with buffer layers less than 6 nm show electrical short circuit between the top and bottom contacts, which may be due to the intercrystal void formation. However, the highly oriented BTO films (having thickness of 150 nm) deposited on a BTO seed layer, with intermediate layers thicker than 7.2 nm, followed by layer by layer coating (BTO amorphous film of 30 nm) and annealing procedure show a well defined hysteresis loop, with characteristic butterfly dielectric response. The BTO thin films (having 150 nm thickness) appear to be very stable up to electric field strengths of about 400 kV/cm, with the occurrence of the breakdown for an electric field greater than 500 kV/cm. The polarization behaviour of the films has not reached the saturation, due to the high possibility of the film breakdown at higher voltages. The films deposited with a 7.2 nm intermediate layer show a dielectric constant of about 270, remnant polarization (2Pᵣ) of about 3 µC/cm², and coercive field (E_{c}) of about 60 kV/cm, whereas the BTO film deposited on a 8.9 nm intermediate buffer layer shows a higher value for both 2Pᵣ ∼ 5 µC/cm², and E_{c} ∼ 100 kV/cm.

To conclude this example, well crystallized BTO thin films may be deposited successfully on bare silicon substrate with an intermediate layer as small as 6 nm in accordance with embodiments of the present invention. It has been demonstrated hereinabove that a variation in the intermediate layer thickness of approximately 1 to 2 nm can influence the crystallization, micro-structure, and electrical properties of the subsequently deposited BTO thin films. The presented method may be used to control the orientations of the BTO films, by controlling the thickness of the intermediate layer and/or by controlling the deposition parameters. The proposed method is found to be efficient in preventing secondary and pyrochlore intermediate state formation, and thus allows high temperature deposition to achieve the desired thin film properties. The problems associated with the formation of intercrystal voids may be overcome by carefully controlling the process as well as buffer layer parameters. The films deposited on intermediate layers as small as 7.2 nm, have suitable properties (e.g. dielectric constant, remnant polarization and coercive field), for use in electronics and photonics devices.

### Second example - sol-gel deposited PZT thin films deposited on silicon

In this second example, Lead Zirconate Titanate (PZT) thin films are deposited on silicon substrate with the conventional 2-methoxy ethanol based chemical solution deposition route. Intermediate layers as small as 4 nm can promote the PZT thin film growth on bare silicon substrate. The annealing temperature and buffer layer sintering conditions may be tuned so as to have an oriented thin film growth. X-ray diffractograms show preferentially oriented PZT thin films along the <100> crystallographic orientation, having single perovskite phase with either tetragonal or rhombohedra geometry. Intermediate layers as thin as 4 nm can promote a preferentially oriented PZT thin film growth, with a dielectric constant of about 300, remnant polarization 2Pᵣ ∼ 16 µC/cm², and coercive field E_{c} ∼ 80 kV/cm. SEM and AFM measurements furthermore indicate the presence of smooth, crack free, uniform layers, with well packed PZT crystal grains of sizes in the range of 40 to 100 nm and with an average surface roughness less than 5 nm.

Ferroelectric thin films have undergone vast investigations over the last few decades because of its useful applications with thin-film capacitors, non-volatile memories, electro-optical devices, and MEMS devices. Among them, PZT thin films / ceramic materials have gained much attraction over their counterparts, owing to their superior dielectric, piezoelectric and electro optic properties. A wide range of methods such as Pulsed Laser Deposition (PLD), Chemical Vapour Deposition (MOCVD) or RF magnetron Sputtering have already been proposed and demonstrated for the PZT thin film growth. However, chemical solution deposition (CSD) has wide acceptance over the other techniques because of its low capital investment, simple processing, and the easy composition control.

The epitaxial deposition of the PZT thin films have gained much attention, because of its potential applications and the scaling capability of future electronics and photonics devices, on CMOS based fabrication platforms. However, the epitaxial growth of PZT thin films on silicon substrates still remains a challenge. It has been reported that the depositions at elevated temperatures can cause severe chemical reactions at the PZT / silicon interfaces and the interdiffusion of the constituent elements result in intermediate pyrochlore formation rather than a pure perovskite phase. Different techniques have already been proposed and demonstrated to aid the thin film growth with either a seed or an intermediate barrier layer.

Many applications of the ferroelectric thin films such as integrated optical devices, metal-ferroelectric semiconductor field effect transistor (MFS-FET), demand the deposition of the ferroelectric thin films with ultra-thin dielectric intermediate barrier layer to explore its potential functionalities. The issues associated with the conformalily of the spin coating makes it essential to estimate the minimal critical thickness that supports the thin film growth, and the thickness dependency on the dielectric, piezoelectric, electro optic, and ferroelectric properties of the thin films. The deposition of the PZT thin films on any non planar textured substrates (or devices) requires the thickness of the intermediate layers to be greater than the critical value to enhance the material properties and to improve the device performance. However, in accordance with embodiments of the present invention, PZT thin films may be grown directly on bare silicon <100> substrates by a chemical solution deposition technique. The influence of intermediate layers as small as 3 - 10 nm on the crystallization, micro-structural, dielectric, and ferroelectric properties of the PZT thin films have been investigated in detail. The heat treatments as well as thickness properties of the buffer layers and the ferroelectric thin films may be tuned, so as to have a well oriented, crack free, smooth film on silicon substrates.

In this example, lead acetate try-hydrate Pb(CH₃COO)₂, Titanium Butoxide Ti(C₄H₉O) and zirconium (IV) propoxide Zr(OCH₂CH₂CH3) were used as the starting materials with 2-methoxy ethanol as the solvent for the preparation of PZT precursor solution. Firstly, Lead acetate tri-hydrate [sigma Aldrich] is dissolved in 2-methoxy ethanol and vacuum distilled at 100°C for 2 hours to remove the attached water content from the precursor molecules. The solution is then allowed to cool down to 70 °C, prior to further processing. Secondly, the titanium and zirconium precursors were added dropwise in the desired molar proportions (Zr: Ti: 58:42) under constant refluxing. The solution was then constantly stirred over 24 hours on a hot plate at 70 °C before spin coating on to the silicon substrate.

The molarity of the PZT solution was controlled to achieve a film thickness of 45 to 60 nm on a single deposition and post deposition annealing treatment. In order to investigate the thickness dependency of the intermediate barrier layer on the crystallization, dielectric, and ferroelectric properties of the PZT thin film, buffer solutions with different molar concentrations were prepared by dissolving lanthanum nitrate hydrate in 2-propanol. Firstly, Polyvinyl pyrrolidone (45 in water) dissolved in 2-propanol was spin coated on to the silicon substrate as an adhesion layer prior to the buffer layer deposition. The intermediate buffer layers were spin-casted at 3000 rpm for 45 seconds, and subjected to a heat treatment at 450 °C for 10 minutes. Secondly, the PZT precursor solution was spin coated at 3500 rpm for 45 seconds, followed by pyrolysis of the films on a hot stage at 350 °C for 10 minutes. In the subsequent steps, the silicon substrates with PZT amorphous films are heat treated to 500 °C- 600°C for 15 minutes in ambient air, with a tube annealing furnace. The ramping rates for heating and cooling of the specimen in the annealing system were adjusted to 100 °C/min and 50 °C/min run respectively. The thicker PZT films can be deposited by repeating the spin coating- pyrolysis process over many steps. However, this process was limited to 3 to 4 steps, since very thick layers result in crack formation during the high temperature sintering process.

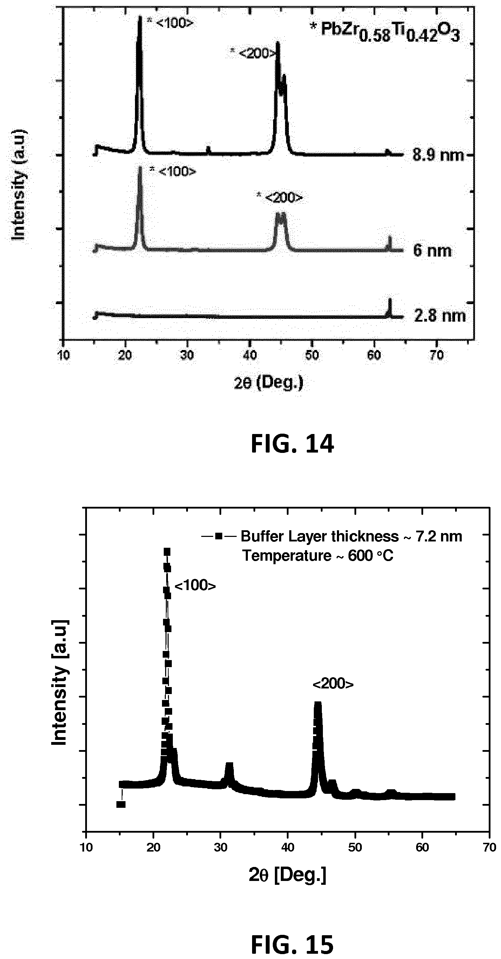

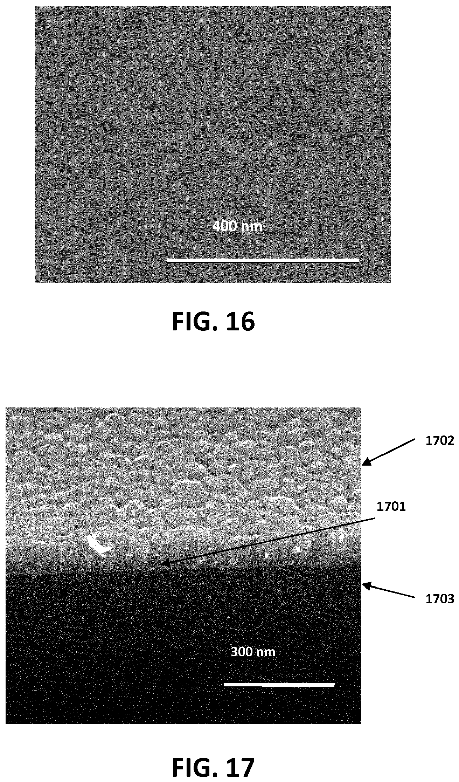

FIG. 13 and FIG. 14 show the X-ray diffractograms of PZT thin films deposited on bare silicon substrate and subjected to a post deposition annealing treatment between 520°C to 600 °C. The intermediate layers of thickness ranging from 2.5 to 10 nm have been used to investigate thin film growth. The experimental results show that intermediate layers as thin as 4.4 nm can efficiently promote the PZT crystallization, along the <100> crystallographic orientation. It can be seen from the measurements that for annealing temperatures from 540 °C to 600 °C, regardless the thickness variation of the intermediate layer (> 4 nm), the PZT thin film is crystallized into a single perovskite phase with a <100> crystal orientation. However for the films deposited at 520 °C, the peak splitting of the XRD patterns can be clearly seen (see FIG. 14). As the thickness of the intermediate layer is further reduced below 4 nm, a large change in the crystallization property was observed. The XRD measurement indicates the presence of dominant pyrochlore intermediate state, and no diffraction peaks corresponding to crystalline PZT was observed. It can also be seen from FIG. 16 that the PLZT film deposited with a buffer layer of 8.9 nm also shows a preferential crystal growth, with a strong diffraction peak along the <100> crystallographic orientation. It is reported before that lanthanum, or strontium doping to the PZT films can further enhance the electro-optic and piezoelectric properties. Experiments have shown that, regardless of the doping, the PZT thin films are highly c-axis textured, which can further improve the properties of such thin films.

It may be seen from the experimental results that high temperature annealing above 600 °C can result in a non-stoichometric PZT growth, eventhough the thickness of the intermediate layer is above the critical value. This may happen due to the highly volatile nature of the constituent lead element (which may be compensated by adding more lead than the stoichometric proportion), and enhanced Pb diffusion into the underlying silicon substrate. Insufficient Pb in the prepared thin films may cause many non-stoichometric structural defects and can result in the degradation of the material properties. It may be useful to increase the thickness of the buffer layer to 10 nm or more to have a stoichometric film when the annealing temperature is above 600 °C . The deposition of a thicker intermediate layer may limit the performance of the ferroelectric film for many different applications, and nonuniformities are clearly evident with thicker intermediate layer because of poor adhesion properties with the underlying organics thin film. However, the PZT films deposited with a considerably lower annealing temperature < 600°C show stoichometric thin film growth eventhough the buffer layer thickness is kept well below 10 nm.

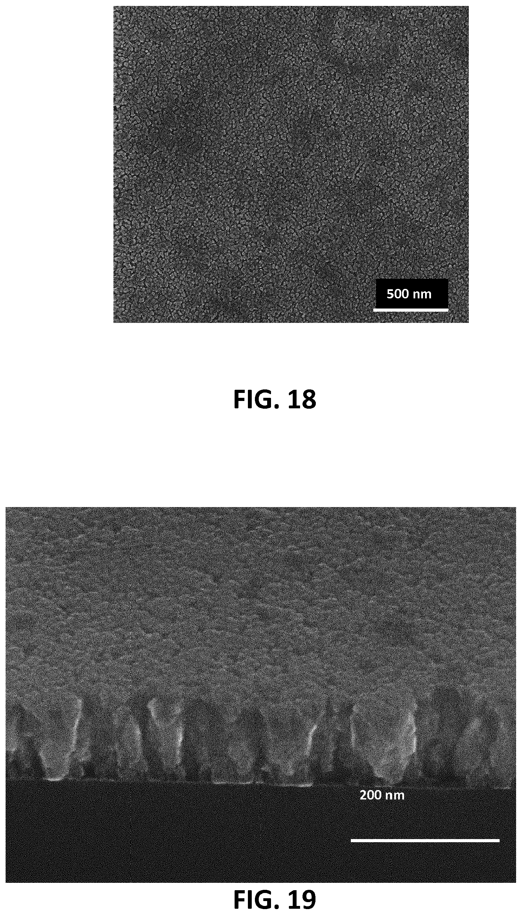

Scanning electron microscope (SEM) images of the PZT thin film grown under the various processing conditions are shown in FIG. 16 to FIG. 19. It can be seen from the SEM / AFM analysis that the micro structural, roughness properties of these films may be influenced by the thickness, and sintering conditions of the intermediate layers and by the annealing conditions of the PZT thin films. FIG. 16 and FIG. 18 represent the top surface images of the PZT films sintered at 600°C and 520 °C. The SEM images indicate the presence of smooth, crack-free, uniform layers with tightly packed polygonal crystal grains on silicon substrate. The average grain size of the film is increased with the increase in the lanthanum nitrate buffer layer thickness as well as the annealing temperature, and which correspond well the XRD results. This variation is attributed to the difference in the interaction strength between the buffer layer and the subsequently deposited PZT thin film. For the films deposited at 600 °C, the grain sizes are 40 - 100 nm, 40 - 60 nm, 20 - 50 nm for films deposited with buffer layers 9 nm, 6 nm, and 4.6 nm respectively. The films deposited on buffer layer with thickness ranging from 4.6 nm to 8.9 nm and annealed at 525 °C, show much smaller grains with average size less than 20 nm. However, the nano-columnar crystal growth is evident for the films annealed at both 600 °C and 520 °C.
The cross section images of the PZT thin film was prepared by cleaving the silicon substrates. It may be noted that the exposed silicon cleavage planes are visible in FIG. 17 and FIG. 19. FIG. 17 shows a SEM image of the PZT film 1702 deposited on silicon 1703, with a buffer layer 1701 having a thickness of 8.9 nm.

The presence of the ultra small intermediate layer is visible from the SEM images, and it shows a good match between data obtained from the ellipsometer measurements.

The films deposited on buffer layer with thickness ranging from 4.6 nm to 8.9 nm and annealed at 525 °C, show much smaller grains with average size less than 20 nm. However, an exact estimation of the grain size is difficult, since the grain boundaries cannot be distinguished so easily. The SEM images indicate smooth, crack free film with a nano structured columnar growth.

The surface roughness and grain size of the PZT samples were measured by atomic force microscopy (AFM) analysis. The measurements show that PZT films deposited on silicon substrates seem to be smooth, uniform, crack free, with tightly packed polygonal crystal grains. The average roughness of the film measured over a 5 µm X 5 µm scan area show an average surface roughness of about 5 nm, for the films annealed at 600°C, with intermediate layers of, 4.6 nm and 6 nm..

Capacitance versus voltage characteristics of the films were measured by using a HP4192ALF impedance analyser with a 4-prob measurement set-up. These measurements were conducted by depositing a top electrode with either chromium or indium tin oxide (ITO) (Specifications: Area ∼3.14 mm², thickness ∼50nm) by RF magnetron sputtering.

A sawyer tower circuit has been used to measure the polarization - electric field properties of the thin films, with the electric hysteresis measurements. The measurements were carried out at 1 kHz with an ac-voltage swing of 20 V - PP.

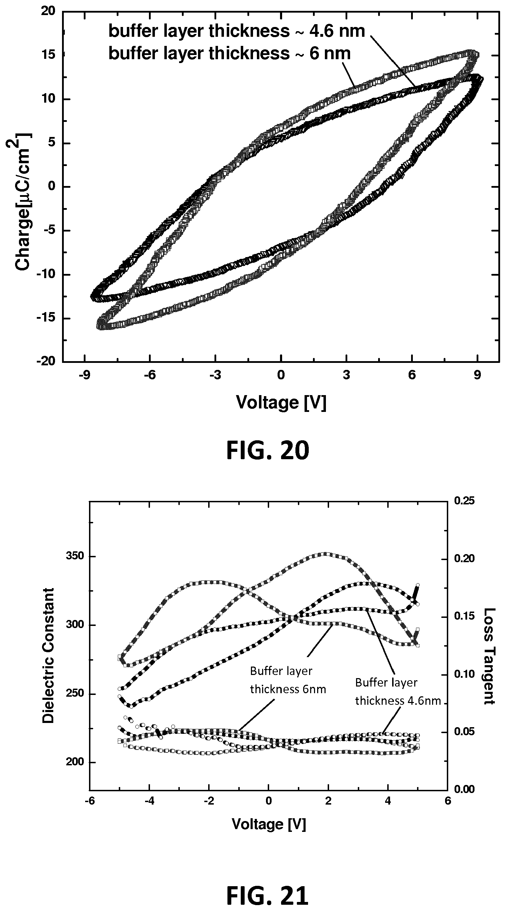

The electrical properties of the thin films were measured with the help of a polarization-electric field (P-E) hysteresis loop. A tower-sawyer circuit has been used to carry out the P-E hysteresis measurements. It can be seen from FIG. 20 that the remnant polarization and coercive field of the films may be influenced by the properties of the intermediate layers. The PZT film annealed at 525 °C, with intermediate layer thickness of 4.6 nm, and 6 nm, show a remnant polarization (2Pᵣ) of 18 µC/cm², and 16 µC/cm², respectively. However, as the temperature of deposition increased above 600°C, significant reductions in the remnant polarization of the films may be noticed. The degradation in the remnant polarization of the films annealed at temperatures greater than 600 °C may indicate increased interdiffusion of Pb into the underlying silicon substrates.

The hysteresis nature of the PZT films can also evident from the C-V measurements as shown in FIG. 21. It can also be seen that the thickness of the intermediate layer influence the dielectric nature of the PZT thin film. FIG. 21 represents the films deposited at 520 °C, with intermediate layers of different thicknesses. It is found that the intermediate layers as thin as 4.4 nm can aid the growth of PZT films with dielectric constants of about 310.

In conclusion for this example, successful growth of PZT thin films on a silicon substrate using a conventional 2-methoxy ethanol based chemical solution deposition technique has been demonstrated. An ultra-thin intermediate layer of ∼ 4 nm thickness can support the PZT thin film growth in accordance with embodiments of the present invention. The crystallinilty, micro structural, and roughness properties of the films were studied using X-ray diffraction, SEM and AFM measurements respectively. These measurements indicated a preferential PZT growth with nano-columnar grain structure, while the roughness of the films was found to be within ∼ 5 nm. The dielectric properties of the films as estimated with an LCR meter show a good dielectric response of about 310, even for the films deposited with an intermediate layer of ∼ 4 nm thickness. The ferroelectric nature of the films was shown by both C- V and P-E hysteresis measurements. The coercive field and remnant polarization of the films were found to be 70 kV/cm, 15 µC/cm² respectively.

### Third example - sol-gel deposited LiNbO₃ thin films deposited on silicon

Lithium Niobate (LiNbO3) ceramic and thin film material has been used extensively for integrated optical applications, over the last few decades. Many electro-optic, piezo-electric and pyro-electric devices have been demonstrated already on this platform. High speed electro-optic optic modulators (40 Gbps) based on LiNbO₃ are commercially available. In this example, it is demonstrated that highly c-axis textured lithium niobate films can be deposited on silicon platform with ultra thin intermediate layer (∼ 10 nm). The 2-methoxy ethanol sol-gel route similar to the two previous examples has been used to deposit LiNbO₃ thin film on a silicon substrate.

Reagent grade Lithium ethoxide Li(CH₃COO)₂, and Niobium(V)Pentaethoxide Nb(C₄H₉O)₄, were chosen as the source materials for lithium and niobium, whereas glacial acetic acid and 2-methoxy ethanol was used as the solvents. Firstly, lithium ethoxide is dissolved completely in acetic acid at room temperature. Secondly, niobium ethoxide is added dropwise, in 1:1 molar proportion, with constant refluxing at 80 °C. The solution is then allowed to come to the room temperature with continue refluxing over 24 hours. The solution has been filtered prior to the deposition process.

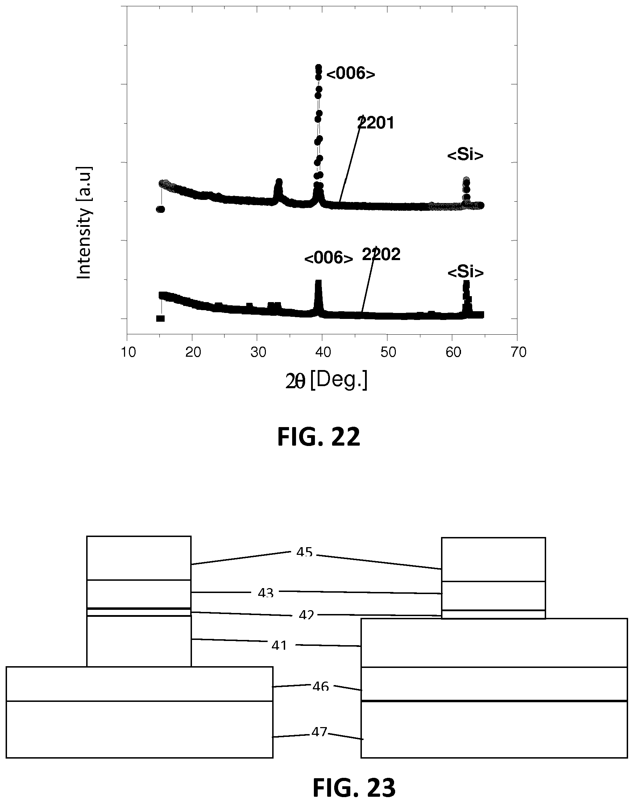

The intermediate buffer layers were spin-casted at 3000 rpm for 45 seconds, and subjected to a heat treatment at 450 °C for 10 minutes. Secondly, the (LiNbO₃) precursor solution was spin coated at 2000 rpm for 45 seconds, followed by pyrolysis of the films on a hot stage at 350 °C for 10 minutes. In the subsequent steps, LiNbO₃ amorphous films were annealed at 650°C for 15 minutes in ambient air, with a tube annealing furnace. The ramping rates for heating and cooling of the specimen in the annealing system were adjusted to 100 °C/min and 50 °C/min run respectively. The thicker PZT films can be deposited by repeating the spin coating- pyrolysis process over many steps. However, this process was limited to 3 to 4 steps, since very thick layers result in crack formation during the high temperature sintering process. The XRD measurements of the LiNbO₃ deposited at 650 °C, with buffer layers of different thickness are shown in FIG. 22. FIG. 22 shows results for a buffer layer 2201 having 7.2 nm thickness, and for a buffer layer 2202 having 10 nm thickness. The results indicate that the film is crystallized into a pure perovskite phase with hexagonal geometry. The films have a high C-axis texture with strong diffraction peaks along the <006> crystallographic orientation.

### Fourth example - heterogeneous integration of ferroelectric thin film and silicon slot waveguide

The high electro-optic coefficient of perovskite ferroelectric thin films may be advantageous for applying such thin films in electro-optic modulators. In this example, simulations are presented in which a solid-state microstructure according to embodiments of the present invention is described having a silicon-on-insulator substrate. To fabricate such a device, one of the important challenges is associated with the epitaxial deposition of the ferro-electric thin films onto silicon. It is important to have an optically non-absorbing layer which is thin enough as will be demonstrated by the simulations. The intermediate layer presented in this example, which is arranged between the Si and the ferroelectric thin film, was found to be thin enough to ensure good operation.

Recently, slot waveguides have gained much attention in the photonics community. In this structure a low index material is sandwiched between two high index materials (for example silicon). Due to the continuity of the normal component of the displacement vector (D=εE), the TM-like mode in the low index region is enhanced by a factor of n_{Si}²/nₛₗₒₜ². An oriented ferroelectric material (on an ultra-thin intermediate buffer layer) can be used in the low index slot region to obtain an electro-optic device. Thanks to the high optical electric field confinement in the slot region of the waveguide, the refractive index change due to the electro-optic material is efficiently transferred to a change in effective index of the propagating electromagnetic mode.

FIG.23 shows the proposed slot structure with a PZT, PLZT or BaTiO3 thin-film layer 43 sandwiched between a crystalline Si layer 41 and the top deposited amorphous Si material 45. The bottom high index layer 41 may be crystalline-Si with a refractive index of 3.45 and thickness of 220 nm. The bottom layer 41, which may form the substrate of the solid-state microstructure, may be part of the SOI (silicon-on-Insulator) wafer, for example together with a SiO2 layer 46 and a silicon substrate base 47. The top high index layer 45 may be formed by LPCVD deposited amorphous silicon (a-Si), for example forming a layer 220 nm thickness. The low index region may be formed with a 10 nm thickness intermediate layer 42 and a 100 nm thin-film layer 43, forming the electro-optic thin film. The widths of the waveguides may be kept at 3 µm, so that the devices can be manufactured by conventional U-V lithography processes. The lateral structures may be fabricated by photolithography followed by anisotropic etching.

In this example, the thickness of the slot material is 100 nm, such that a high optical electric field confinement may be achieved in the slot. If the thickness of the intermediate layer is increased, this may reduce the confinement, which also reduces the light interaction with the electro-optic thin film. Thus, the efficiency, e.g. the effective index change versus applied voltage, and the tuning range of the device may be reduced.. Since the refractive index of the intermediate layer (∼ 1.9) is less than the ferroelectric thin film (2.4), thicker intermediate layers may result in a strong electric field confinement in the intermediate layer material, and thus the properties of the electro-optic device may be degraded.

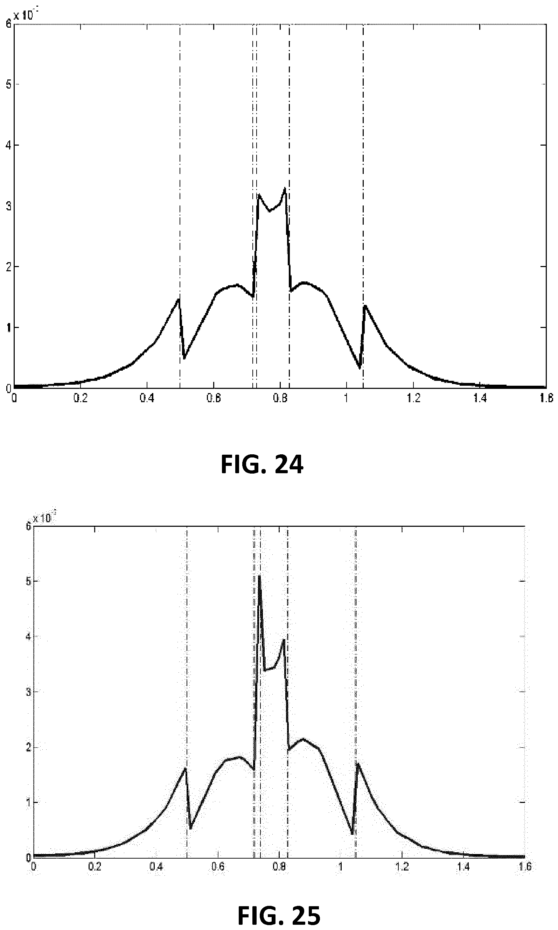

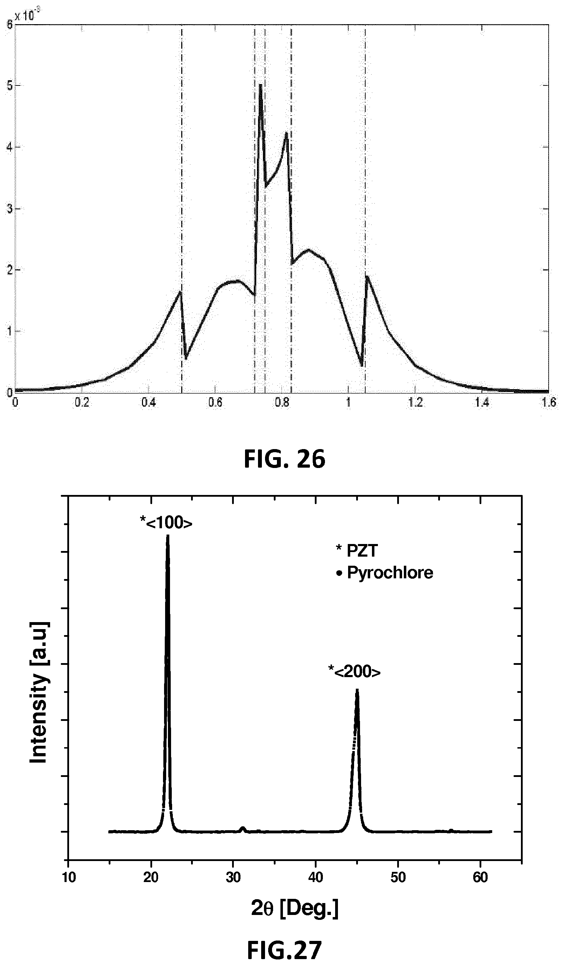

The mode profiles of a PZT/BTO-Si slot structure are shown in FIG. 24 to FIG. 26. It can be seen from FIG. 48 that when the intermediate layer thickness is 10 nm, the TM-like mode of the slot structure appears symmetric. However, as the intermediate layer thickness is increased from 10 nm to 20 nm, shown in FIG. 25, and further to 30 nm, shown in FIG. 26, an increase in the optical intensity within the buffer layer is observed. It is due to the slot-like bahaviour of the thin buffer layers between the high index silicon and ferroelectric thin film. To have a better light-ferroeletric thin film interaction for a future electro-optic device, it is essential to keep the buffer layer as thin as possible.

### Fifth Example - Neodymium Oxide Nitrate (NdONO3) buffer layer for preferentially oriented PZT thin films

Reagent grade Neodymium Nitrate Hexahydrate Nd(NO₃)₃.6H₂O dissolved in 2-propanol was used to prepare a neodymium oxide nitrate (NdONO₃)buffer layer. The solution was continuously refluxed at 50 °C for 1 hour, before cooling back to room temperature. The refluxing was continued further for 24 hours, before filtering the solution to spin coat onto the substrate. The molarity of the solution was adjusted to 0.02 M to obtain a buffer layer with thickness < 10 nm. The precursor solution was spin coated at 3000 r.p.m for 45 seconds with an acceleration and deceleration speed set to 600 r.p.m/sec. The substrate was then heat treated at 200 °C on a hot plate and subsequently sintered in a tube annealing furnace at 460 °C to prepare the NdONO₃ buffer layer for 5 minutes.

To test the influence of the NdONO₃ buffer layer on the perovskite thin film growth, a PZT thin film was deposited on the silicon substrate with a buffer layer obtained as described above. The PZT precursor solution, which was identical to the solution used in the second example hereinabove, was spin coated at 3500 rpm for 45 seconds, followed by pyrolysis of the films on a hot stage at 350 °C for 10 minutes. In the subsequent steps, the silicon substrates with PZT amorphous films were heat treated to 600°C for 15 minutes in ambient air, using a tube annealing furnace.

An X-ray diffraction measurement was carried out to verify the PZT thin film growth, as shown in FIG. 27. These measurements may demonstrate that the PZT film deposited on the NdONO₃ buffer layer has been crystallized into a single perovskite phase, with no indication of any pyrochlore intermediate states. The films showed preferential crystal growth with strong diffraction peaks along the <100> crystallographic orientation.

### Sixth Example - Praseodymium Oxide Nitrate (PᵣONO₃) buffer layer for preferentially oriented PZT thin films

To prepare the buffer layers reagent grade Praseodymium Nitrate Hexahydrate (Sigma Aldrich Ltd.) is dissolved in 2-propanol, and refluxed continuously over 24 hours, at room temperature. The resulting solution shows a pale green colour. The concentration of the solution is adjusted to 0.3 M and filtered prior to the spin coating. The solution is then spin-coated on to the bare silicon substrate at 3000 r.p.m for 45 seconds. In the subsequent step, the layer is heat treated at 440 ° C for 15 min, to initiate the PᵣONO₃ layer formation. All the oxide nitrate films found below 430 °C are non-stoichiometric and unstable. The heat treatment for the stoichiometric, stable, PᵣONO₃ films is limited to temperatures between 430 °C and 460 °C. Above 465 °C the films PᵣONO₃ films are decomposed into their corresponding oxide state (PᵣO_{1.833}). We used a thin PᵣONO₃ layer (8- 12 nm), as buffer layer to further investigate the influence of oxide nitrate phase on the crystallization of Ferro-electric thin films.

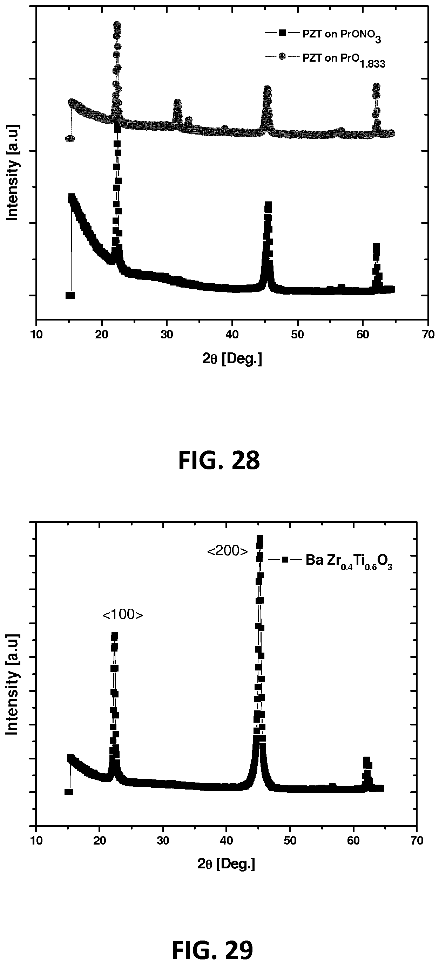

To verify the thin film growth we used PZT (∼ 100 nm) and BZT thin films as test layers. For the PZT thin film deposition, we followed the same parameters as mentioned in the second and fifth Example. The PZT films are annealed at 600 °C for 15 minutes prior to the X-ray diffraction measurements. The XRD measurements indicate that the films are crystallized into a stoichiometric single perovskite phase with a tetragonal geometry, regardless the buffer layer thickness. The films contain densely packed crystal grains, without any cracks. The XRD results are as shown in Fig. 28 and Fig. 29.

### Seventh Example - Samarium Oxide Nitrate (SₘONO₃) buffer layer for preferentially oriented PZT thin films

We followed the same synthesis method as mentioned with second, fifth, and sixth example for the preparation SₘONO₃ buffer layer. The samarium nitrate hydrate solution is spin coated on to the silicon substrate. These films are then heat treated at 470 °C for 10 min to form SₘONO₃ as the intermediate crystalline phase. It is reported that the oxide nitrate phase of samarium exists over a temperature range from 450 °C to 490 °C. The films are converted into a Sm₂O₃ oxide phase above 750 °C. We have used buffer layers of 7 to 10 nm for our experiments.

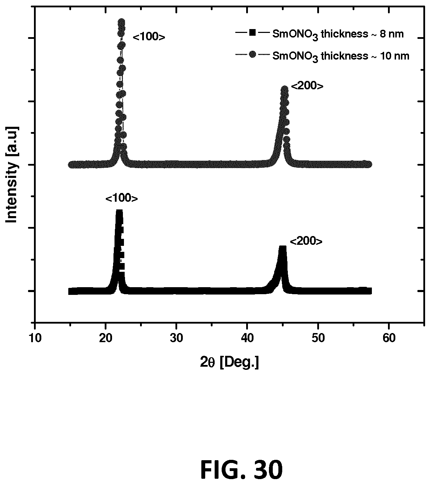

A PZT test layer of 100 nm is deposited on silicon, covered with SₘONO₃ buffer layer. The X-ray diffraction measurements show that the PZT films have identical properties to that of the films deposited with the second, fifth and sixth examples. Regardless the buffer layer thickness, pyrolysis temperature and annealing temperature the films show a preferential orientation along the <100> crystallographic direction with densely packed crystal grains. The XRD measurements with the SmONO₃ buffer layers are shown in Fig.30.

We also noticed that the orientations of the ferroelectric thin film deposited on the oxide nitrate buffer layer is independent of the substrate orientation. To prove this, we carried out the experiments on bare glass, Silicon Dioxide (SiO2), Silicon Nitride (Si₃N₄), Indium Tin Oxide (ITO), and Aluminum Oxide (Al₂O₃) substrates. The measurements indicate that both the amorphous and crystalline substrates support the thin film growth with a preferred crystallographic (<100> direction) orientation.

## Claims

1. A solid-state microstructure (10) comprising
- a substrate (1);
- an intermediate layer (2) arranged on said substrate (1), and
- a thin-film layer (3) arranged on said intermediate layer (2), said thin-film layer (3) comprising a preferentially oriented perovskite-related material,
- **characterized in that** the intermediate layer comprises a lanthanide oxynitrate.

2. The solid-state microstructure (10) according to claim 1, in which said intermediate layer (2) has a thickness (d) less than 20 nm.

3. The solid-state microstructure (10) according to claim 1 or claim 2, in which said preferentially oriented perovskite-related material comprises barium titanate, barium zirconium titanate, strontium titanate, lead lanthanum zirconate titanate , lithium niobate or lead zirconate titanate.

4. The solid-state microstructure (10) according to any of the previous claims, in which said substrate comprises any of silicon, germanium, MgO₂, coated silicon with a Ti coating, coated silicon with a SiO2 coating, coated silicon with an Al₂O₃ coating, glass or glass with an ITO coating.

5. A method (20) for manufacturing a solid-state microstructure (10), the method comprising:
- obtaining (11) a substrate (1);
- forming (13) an intermediate layer (2) on said substrate (1),; and
- forming (15) a thin-film layer (3) on said intermediate layer (2), in which said thin-film layer (3) comprises a preferentially oriented perovskite-related material, **characterized in that** forming an intermediate layer comprises forming an intermediate layer comprising a lanthanide oxynitrate.

6. The method (20) according to claim 5, in which said intermediate layer (2) has a thickness of less than 20 nm.

7. The method (20) according to any of claims 5 to 6, in which forming (13) said intermediate layer (2) comprises applying (12) a chemical material onto the substrate (1), in which said chemical material comprises lanthanum nitrate or neodymium nitrate.

8. The method (20) according to claim 7, in which applying (12) said chemical material comprises spin-coating, dip coating, k-bar coating or screen printing the chemical material onto the substrate (1).

9. The method (20) according to any of claims 7 to 8, in which forming (13) said intermediate layer (2) comprises applying (14) a heat treatment to said intermediate layer (2) in order to form lanthanide oxynitrate in said intermediate layer or applying (14) a heat treatment to said intermediate layer (2) at a temperature in the range from 440°C to 570°C in order to form lanthanide oxynitrate in said intermediate layer.

10. The method (20) according to any of claims 7 to 9, furthermore comprising the step of applying (16) an adhesion promoter to the substrate (1) prior to applying (12) said composition or comprising the step of applying (16) an adhesion promoter comprising a polyvinyl pyrrolidone solution to the substrate prior to applying (12) said composition.

11. The method (20) according to any of claims 5 to 10, in which forming (15) the thin-film layer (3) on said intermediate layer (2) comprises spin-coating (17) a precursor solution for the preferentially oriented perovskite-related material.

12. The method (20) according to claim 11, in which forming (15) the thin-film layer (3) on said intermediate layer (2) further comprises pyrolysis (18) of the thin-film layer.

13. The method according to claim 12, in which forming (15) the thin-film layer comprises repeating (19) at least once said spin-coating (17) and said pyrolyzing (18).

14. A device comprising a solid-state microstructure according to any of claims 1 to 4, wherein the device is any of a piezoelectric actuator or sensor, an acousto-optic device, a ferroelectric data memory, a capacitor, an electro-optic modulator or an electro-optic switch, an elasto-optic device, a pyro-electric detector or a MEMS device.

15. Use of a solid-state microstructure according to any of claims 1 to 4 in any of a piezoelectric actuator or sensor, an acousto-optic device, a ferroelectric data memory, a capacitor, an electro-optic modulator or electro-optic switch, an elasto-optic device, a pyro-electric detector or a MEMS device.

## Patentansprüche

1. Festkörpermikrostruktur (10) umfassend
- ein Substrat (1);
- eine Zwischenschicht (2), die auf dem Substrat (1) angeordnet ist, und
- eine Dünnfilmschicht (3), die auf der Zwischenschicht (2) angeordnet ist, wobei die Dünnfilmschicht (3) ein bevorzugt orientiertes Perowskit-verwandte Material umfasst
- **dadurch gekennzeichnet, dass** die Zwischenschicht ein Lanthanoidoxynitrat umfasst.

2. Festkörpermikrostruktur (10) nach Anspruch 1, wobei die Zwischenschicht (2) eine Dicke (d) von weniger als 20 nm aufweist.

3. Festkörpermikrostruktur (10) nach Anspruch 1 oder Anspruch 2, wobei das bevorzugt orientierte Perowskit-verwandte Material Bariumtitanat Bariumzirkoniumtitanat, Strontiumtitanat, Bleilanthanzirkonattitanat, Lithiumniobat oder Bleizirkonattitanat umfasst.

4. Festkörpermikrostruktur (10) nach einem der vorhergehenden Ansprüche, wobei das Substrat Silicium, Germanium, MgO₂, beschichtetes Silicium mit einer Ti-Beschichtung, beschichtetes Silicium mit einer SiO₂-Beschichtung, beschichtetes Silicium mit einer Al₂O₃-Beschichtung, Glas oder Glas mit einer ITO-Beschichtung umfasst.

5. Verfahren (20) zum Herstellen einer Festkörperstruktur (10), wobei das Verfahren Folgendes umfasst:
- Erhalten (11) eines Substrats (1);
- Bilden (13) einer Zwischenschicht (2) auf dem Substrat (1), und
- Bilden (15) einer Dünnfilmschicht (3) auf der Zwischenschicht (2), in der die Dünnfilmschicht (3) ein bevorzugt orientiertes Perowskit-verwandte Material umfasst,
- **dadurch gekennzeichnet, dass** das Bilden einer Zwischenschicht das Bilden einer Zwischenschicht umfasst, die ein Lanthanoidoxynitrat umfasst.

6. Verfahren (20) nach Anspruch 5, wobei die Zwischenschicht (2) eine Dicke (d) von weniger als 20 nm aufweist.

7. Verfahren (20) nach einem der Ansprüche 5 bis 6, wobei das Bilden (13) der Zwischenschicht (2) das Aufbringen (12) eines chemischen Materials auf das Substrat (1) umfasst, wobei das chemische Material Lanthannitrat oder Neodymnitrat umfasst.

8. Verfahren (20) nach Anspruch 7, wobei das Aufbringen (12) des chemischen Materials das Schleuderbeschichten, Tauchbeschichten, K-Stab-Beschichten oder Siebdrucken des chemischen Materials auf das Substrat (1) umfasst.

9. Verfahren (20) nach einem der Ansprüche 7 bis 8, wobei das Bilden (13) der Zwischenschicht (2) das Anwenden (14) einer Wärmebehandlung auf die Zwischenschicht (2), um Lanthanidoxynitrat in der Zwischenschicht zu bilden, oder das Anwenden (14) einer Wärmebehandlung auf die Zwischenschicht (2) bei einer Temperatur im Bereich von 440 °C bis 570 °C umfasst, um Lanthanidoxynitrat in der Zwischenschicht zu bilden.

10. Verfahren (20) nach einem der Ansprüche 7 bis 9, ferner umfassend den Schritt des Aufbringens (16) eines Haftvermittlers auf das Substrat (1) vor dem Aufbringen (12) der Zusammensetzung oder umfassend den Schritt des Aufbringens (16) eines Haftvermittler, der eine Polyvinylpyrrolidonlösung umfasst, auf das Substrat vor dem Aufbringen (12) der Zusammensetzung.

11. Verfahren (20) nach einem der Ansprüche 5 bis 10, wobei das Bilden (15) der Dünnfilmschicht (3) auf der Zwischenschicht (2) das Schleuderbeschichten (17) einer Vorläuferlösung für das bevorzugt orientierte Perowskit-verwandte Material umfasst.

12. Verfahren (20) nach Anspruch 11, wobei das Bilden (15) der Dünnfilmschicht (3) auf der Zwischenschicht (2) ferner eine Pyrolyse (18) der Dünnfilmschicht umfasst.

13. Verfahren nach Anspruch 12, wobei das Bilden (15) der Dünnfilmschicht das mindestens einmalige Wiederholen (19) des Schleuderbeschichtens (17) und des Pyrolysierens (18) umfasst.

14. Vorrichtung umfassend eine Festkörpermikrostruktur nach einem der Ansprüche 1 bis 4, wobei die Vorrichtung eine beliebige von einem piezoelektrischen Aktuator oder Sensor, einer akustooptischen Vorrichtung, einem ferroelektrischen Datenspeicher, einem Kondensator, einem elektrooptischen Modulator oder einem elektrooptischen Schalter, einer elastooptischen Vorrichtung, einem pyroelektrischen Detektor oder einer MEMS-Vorrichtung ist.

15. Verwendung einer Festkörpermikrostruktur nach einem der Ansprüche 1 bis 4 in einem beliebigen von einem piezoelektrischen Aktuator oder Sensor, einer akustooptischen Vorrichtung, einem ferroelektrischen Datenspeicher, einem Kondensator, einem elektrooptischen Modulator oder einem elektrooptischen Schalter, einer elastooptischen Vorrichtung, einem pyroelektrischen Detektor oder einer MEMS-Vorrichtung ist.

## Revendications

1. Microstructure à l'état solide (10) comprenant
- un substrat (1) ;
- une couche intermédiaire (2) agencée sur ledit substrat (1), et
- une couche de film mince (3) agencée sur ladite couche intermédiaire (2), ladite couche de film mince (3) comprenant un matériau lié à la pérovskite orienté de manière préférentielle,
- **caractérisée en ce que** la couche intermédiaire comprend de l'oxynitrate de lanthanide.

2. Microstructure à l'état solide (10) selon la revendication 1, dans laquelle ladite couche intermédiaire (2) a une épaisseur (d) inférieure à 20 nm.

3. Microstructure à l'état solide (10) selon la revendication 1 ou la revendication 2, dans laquelle ledit matériau lié à la pérovskite orienté de manière préférentielle comprend du titanate de baryum, du titanate de zirconium-baryum, du titanate de strontium, du titanate-zirconate de lanthane et de plomb, du niobate de lithium ou du titanate-zirconate de plomb.

4. Microstructure à l'état solide (10) selon l'une quelconque des revendications précédentes, dans laquelle ledit substrat comprend l'un quelconque parmi du silicium, du germanium, du MgO₂, du silicium revêtu avec un revêtement Ti, du silicium revêtu avec un revêtement SiO₂, du silicium revêtu avec un revêtement Al₂O₃, du verre ou du verre avec un revêtement d'oxyde d'étain et d'indium.

5. Procédé (20) pour fabriquer une microstructure à l'état solide (10), le procédé comprenant :
- l'obtention (11) d'un substrat (1) ;
- la formation (13) d'une couche intermédiaire (2) sur ledit substrat (1) ; et
- la formation (15) d'une couche de film mince (3) sur ladite couche intermédiaire (2), dans laquelle ladite couche de film mince (3) comprend un matériau lié à la pérovskite orienté de manière préférentielle,
**caractérisé en ce que** la formation d'une couche intermédiaire comprend la formation d'une couche intermédiaire comprenant de l'oxynitrate de lanthanide.

6. Procédé (20) selon la revendication 5, dans lequel ladite couche intermédiaire (2) a une épaisseur inférieure à 20 nm.

7. Procédé (20) selon l'une quelconque des revendications 5 ou 6, dans lequel la formation (13) de ladite couche intermédiaire (2) comprend l'application (12) d'un matériau chimique sur le substrat (1), dans lequel ledit matériau chimique comprend du nitrate de lanthane ou du nitrate de néodyme.

8. Procédé (20) selon la revendication 7, dans lequel l'application (12) dudit matériau chimique comprend l'application par centrifugation, l'enrobage par immersion, le revêtement K-bar ou l'impression par sérigraphie du matériau chimique sur le substrat (1).

9. Procédé (20) selon l'une quelconque des revendications 7 ou 8, dans lequel la formation (13) de ladite couche intermédiaire (2) comprend l'application (14) d'un traitement thermique à ladite couche intermédiaire (2) afin de former de l'oxynitrate de lanthanide dans ladite couche intermédiaire ou l'application (14) d'un traitement thermique à ladite couche intermédiaire (2) à une température comprise dans la plage allant de 440 °C à 570 °C afin de former de l'oxynitrate de lanthanide dans ladite couche intermédiaire.

10. Procédé (20) selon l'une quelconque des revendications 7 à 9, comprenant en plus l'étape d'application (16) d'un promoteur d'adhésion au substrat (1) avant l'application (12) de ladite composition ou comprenant l'étape d'application (16) d'un promoteur d'adhésion comprenant une solution de pyrrolidone polyvinylique au substrat avant l'application (12) de ladite composition.

11. Procédé (20) selon l'une quelconque des revendications 5 à 10, dans lequel la formation (15) de la couche de film mince (3) sur ladite couche intermédiaire (2) comprend l'application par centrifugation (17) d'une solution précurseur pour le matériau lié à la pérovskite orienté de manière préférentielle.

12. Procédé (20) selon la revendication 11, dans lequel la formation (15) de la couche de film mince (3) sur ladite couche intermédiaire (2) comprend en outre la pyrolyse (18) de la couche de film mince.

13. Procédé selon la revendication 12, dans lequel la formation (15) de la couche de film mince comprend la répétition (19) au moins une fois de ladite application par centrifugation (17) et de ladite pyrolyse (18).

14. Dispositif comprenant une microstructure à l'état solide selon l'une quelconque des revendications 1 à 4, dans lequel le dispositif est l'un quelconque parmi un actionneur ou un capteur piézoélectrique, un dispositif acousto-optique, une mémoire de données ferroélectrique, un condensateur, un modulateur électro-optique ou un commutateur électro-optique, un dispositif élasto-optique, un détecteur pyroélectrique ou un dispositif MEMS.

15. Utilisation d'une microstructure à l'état solide selon l'une quelconque des revendications 1 à 4 dans l'un quelconque parmi un actionneur ou un capteur piézoélectrique, un dispositif acousto-optique, une mémoire de données ferroélectrique, un condensateur, un modulateur électro-optique ou un commutateur électro-optique, un dispositif élasto-optique, un détecteur pyroélectrique ou un dispositif MEMS.
